# EUROPEAN PATENT APPLICATION

(11) **EP 1 632 976 A2**
(43) Date of publication of application: **08.03.2006**
(21) Application number: 05255397.1
(22) Date of filing: 02.09.2005
(51) Int. Cl.: H01J 17/34, H01J 17/28, H01J 17/49

(54) **Plasma display apparatus including heat sink assembly apparatus**

(30) Priority: 03.09.2004 KR 2004070558
(71) Applicant: LG ELECTRONICS INC., 150-721 Seoul (KR)
(72) Inventor: You, Se Joon, Noryangjin 1-dong, Dongjak-gu, Seoul (KR)
(74) Representative: Neobard, William John

(57) **Abstract**

The present invention relates to a plasma display apparatus including a heat sink assembly apparatus, wherein the length of a TCP film can be reduced over a predetermined length. The plasma display apparatus according to embodiments the present invention includes a plasma display panel (500), a driver IC (550) for generating a driving pulse to drive the plasma display panel, a signal transfer film (540) electrically connected to the plurality of electrodes and the driver IC in such a fashion that the driver IC is located under a lateral side of the plasma display panel, a heat sink (570) spaced apart from the signal transfer film by a predetermined distance, for externally radiating heat of the signal transfer film, a first fastening unit (580) located between the signal transfer film and the heat sink, for separating the signal transfer film and the heat sink by a predetermined distance, and a second fastening unit (530) coupled to the first fastening unit so as to fix the heat sink. According to a plasma display apparatus in accordance with embodiments of the present invention, a driver IC is located under the lateral side of a plasma display panel, thus shortening the length of a signal transfer film. Accordingly, cost can be saved.

## Description

The present invention relates to a plasma display apparatus, and more particularly, to a plasma display apparatus including a heat sink assembly apparatus

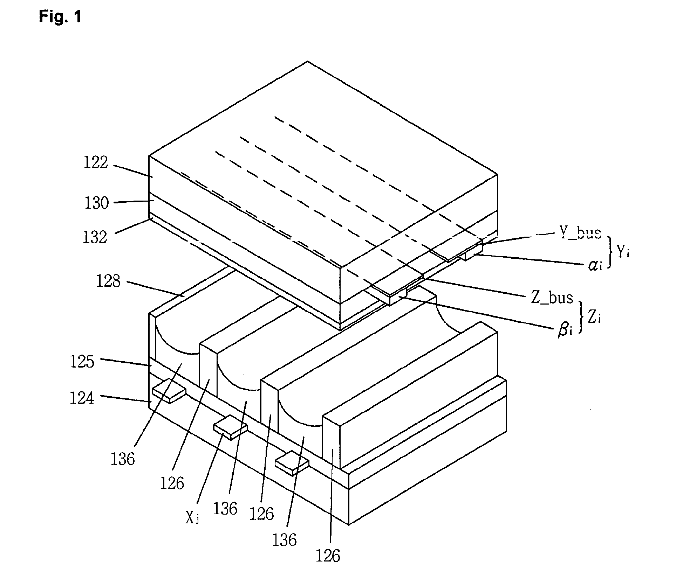

FIG. 1 shows the construction of a general AC type surface discharge plasma display panel. As shown in FIG. 1, the general AC type surface discharge plasma display panel includes a front substrate 122 and a rear substrate 124, which are made of a transparent glass material. The front substrate 122 and the rear substrate 124 are opposite to each other in parallel so as to be spaced apart from each other by a predetermined distance. At this time, barrier ribs 126 are formed on the rear substrate 124 so as to maintain a distance between the front substrate 122 and the rear substrate 124.

Furthermore, an address electrode Xj (j=1, 2,..., m) made of aluminium (Al) or an aluminium alloy are formed between neighbouring barrier ribs 126 parallel to the barrier ribs 126 in order to perform an addressing function. R, G and B phosphors also form a light-emission layer 136 while covering the respective address electrodes.

Meanwhile, a scan electrode and a sustain electrode Yi, Zi (i=1, 2,..., n) are formed in the front substrate 122 perpendicular to the address electrodes. Each of the scan electrode Yi and the sustain electrode Zi has bus electrodes αi, βi and transparent electrodes Y_bus, Z_bus. The bus electrodes αi, βi are made of a metal material. The transparent electrodes Y_bus, Z_bus are made of ITO (Indium Tin Oxide). The transparent electrodes Y_bus, Z_bus are formed on the front substrate 122. The bus electrodes αi, βi are formed on the transparent electrodes Y_bus, Z_bus.

In order to protect the scan electrode Yi and the sustain electrode Zi, a dielectric layer 130 is formed. An MgO layer 132 made of magnesium oxide (MgO) is formed on the dielectric layer 130.

After each of the electrodes Xj,Yi,Zi, the dielectric layer 130 and the light-emission layer 136 are formed, the front substrate 122 and the rear substrate 124 are sealed. After the discharge space 128 is exhausted, moisture on the surface of the MgO layer 132 is removed through baking. An inert mixed gas such as Ne+Xe is then injected into a discharge space 128.

An intersection region of the scan electrode Yi and the sustain electrode Zi, and the address electrode Xj is defined as one display cell P_{(i,j)}. After wall charges are formed within this display cell P_{(i,j)} by addressing discharge occurring between the address electrode Xj and the scan electrode Yi, a sustain pulse is alternately applied between the scan electrode Yi and the sustain electrode Zi. Thus, a sustain discharge is generated within the display cell P_{(i,j)}.

In order for the sustain discharge to be generated in the display cell P_{(i,j)}, a driving pulse has to be applied to each of the electrodes Xj, Yi and Zi according to predetermined timing control. At this time, the driver IC applies the driving pulse to each of the electrodes Xj, Yi and Zi.

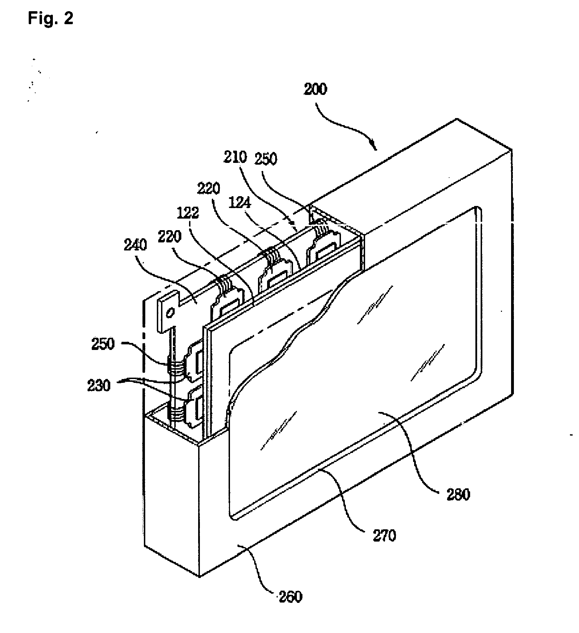

FIG. 2 shows the schematic construction of a general plasma display apparatus, which is partially cut.

As shown in FIG. 2, a plasma display panel includes a front substrate 122 and a rear substrate 124. A reinforcement plate 240 serves to mechanically reinforce the plasma display panel. A casing 260 has an opened display window 270 formed therein. A protection layer 280 formed of a transparent plate is installed in the display window 270 region. Driver ICs 220 and 230 are mounted along the periphery of the plasma display panel. A scan driver IC 230 is connected to the scan electrode Yi and the sustain electrode Zi of the plasma display panel. An address driver IC 220 is connected to the address electrode Xj. The driver ICs 220, 230 are connected to a control circuit, a power supply, and the like.

Meanwhile, a driver IC package consists of a driver signal transfer film for outputting a driving pulse. The signal transfer film electrically connects the driver IC and each of the electrodes of the plasma display panel and includes a Chip On Film (COF), a Tape Carrier Package (TCP) and the like. Recently, in order to save the cost and improve the workability of the plasma display apparatus, the TCP has been used a lot.

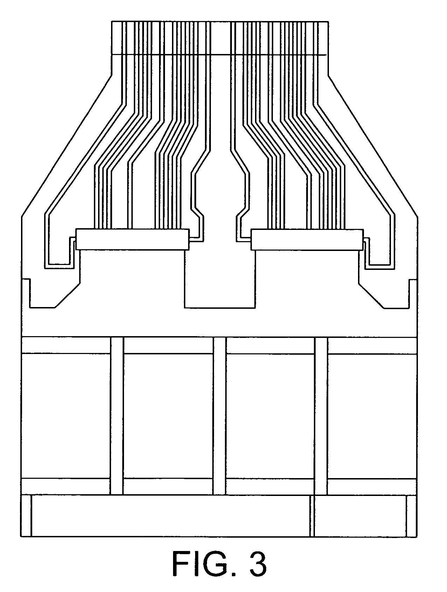

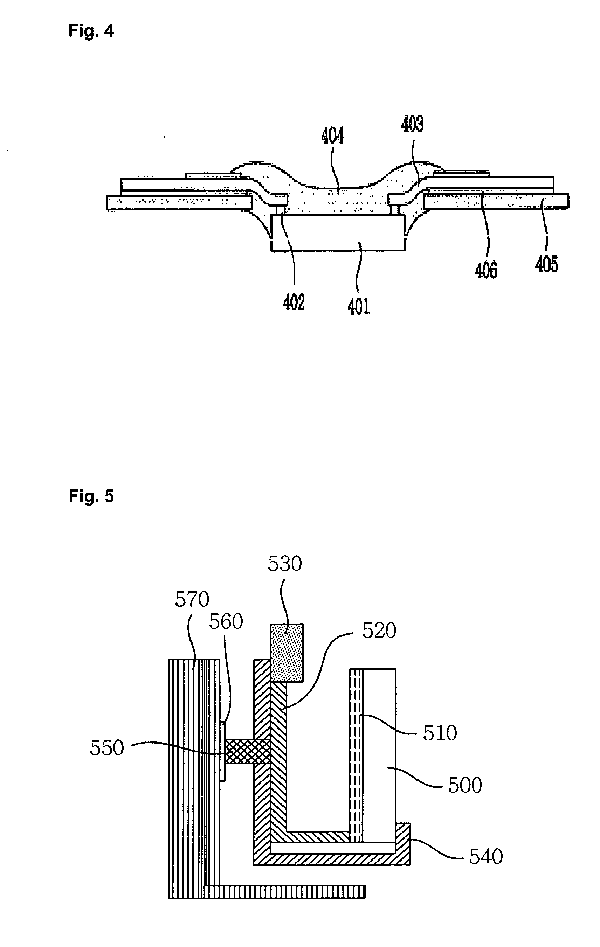

FIG. 3 is a plan view showing an actual picture of a TCP. FIG. 4 is a sectional view of the TCP.

As shown in FIGS. 3 and 4, the TCP has a structure in which a driver IC 401 is located on a tape carrier. Connection bumps 402 disposed on the driver IC 401 are arranged in two rows on both sides of the driver IC 401. Leads 403 are conductive plating and are thermally compressed onto the connection bumps 402. Anisotropic conductive resin 404 covers a connection portion between the leads 403 and the driver IC 401. The leads 403 are coupled to base films 405 by means of an adhesive 406.

If the above-described TCP is used, there are several advantages in the manufacturing process of a plasma display apparatus because the cost of a driver IC package is reduced and supply and adhesion processes of the driver IC package are automated.

Meanwhile, since a recent driver IC package supports a driver IC having a large number of output pins, reducing heat is an important design factor. Accordingly, heat of a recent driver IC package is reduced through a heat sink.

FIG. 5 is a lateral sectional view of a heat sink assembly apparatus for a TCP, which is used in a conventional plasma display apparatus.

As shown in FIG. 5, the conventional heat sink assembly apparatus includes a heat radiation plate 510, a TCP support frame 520, a driving board 530, a TCP film 540, a driver IC 550, a thermal tape 560 and a heat sink 570.

The heat radiation plate 510 is attached to the rear of a lower plate 500 of a plasma display panel and is connected to the driving board 530 through the TCP support frame 520. The TCP support frame 520 supports the TCP film 540. Furthermore, on the TCP support frame 520 is disposed the driver IC 550. The driving board 530 is electrically connected to the lower plate 500 of the plasma display panel through the driver IC 550.

Meanwhile, the heat sink 570 is attached to the driver IC 550 by the thermal tape 560. Accordingly, heat generated from the driver IC 550 is transferred to the heat sink 570 and then discharged in the air. Therefore, the heat problem of the driver IC 550 can be solved.

As described above, if the TCP is applied to the driver IC package, the cost of the package itself can be saved and supply and adhesion processes of the package can be automated. More particularly, in order to maximize the cost saving effect, it is most effective to reduce the length of the TCP film 540, which occupies about 40 to 50 % of the total TCP cost.

In order to reduce the length of the TCP film 540, however, the driving board 530 has to be moved downwardly. If the driving board 530 is moved downwardly, a portion at which the heat sink 570 and the driving board 530 overlap is widened. Accordingly, elements, which are mounted in the driving board 530 and have a predetermined height, can generate mechanical interference with the heat sink. Therefore, there is a limit to reducing the length of the TCP film 540 due to such mechanical interference.

It is an object of embodiments of the present invention to provide a plasma display apparatus including a heat sink assembly apparatus wherein the length of a TCP film can be reduced over a predetermined length.

The invention is defined in the independent claims. Some preferred features of the invention are defined in the dependent claims.

A plasma display apparatus according to an embodiment of the present invention includes a plasma display panel including a plurality of electrodes, a driver IC for generating a driving pulse to drive the plasma display panel, and a signal transfer film electrically connected to the plurality of electrodes and the driver IC in such a fashion that the driver IC is located under a lateral side of the plasma display panel.

In embodiments of the invention, the plasma display apparatus further includes a heat sink spaced apart from the signal transfer film by a predetermined distance, for externally radiating heat of the signal transfer film, a first fastening unit located between the signal transfer film and the heat sink, for separating the signal transfer film and the heat sink by a predetermined distance, and a second fastening unit coupled to the first fastening unit so as to fix the heat sink.

In embodiments of the invention, the plasma display apparatus further includes a support frame for supporting the signal transfer film by way of the fastening of the first fastening unit and the second fastening unit.

In embodiments of the invention, the first fastening unit is a pemnut and the second fastening unit is a screw.

In embodiments of the invention, the signal transfer film is a TCP film.

In embodiments of the invention, the first fastening unit includes a distance sustain unit for sustaining a distance between the signal transfer film and the heat sink, and a passing-through portion that penetrates the heat sink and has a diameter smaller than that of the distance sustain unit.

In embodiments of the invention, a thermal pad is inserted between the driver IC and the heat sink.

In embodiments of the invention, the heat sink includes a fixing hole, which fixing hole may be elliptical.

In embodiments of the invention, the heat sink extends at one side toward a rear surface of the driving board.

A heat sink assembly apparatus according to an embodiment of the present invention includes a driver IC for generating a driving pulse to drive the plasma display panel, a signal transfer film electrically connected to the plasma display panel and the driver IC in such a fashion that the driver IC is located under a lateral side of the plasma display panel, a heat sink spaced apart from the signal transfer film by a predetermined distance, for externally radiating heat of the signal transfer film, a first fastening unit located between the signal transfer film and the heat sink, for separating the signal transfer film and the heat sink by a predetermined distance, and a second fastening unit coupled with the first fastening unit so as to fix the heat sink.

Further objects and advantages of embodiments of the invention can be more fully understood from the following detailed description taken in conjunction with the accompanying drawings in which:
FIG. 1 shows the construction of a general AC type surface discharge PDP;
FIG. 2 shows the schematic construction of a general plasma display apparatus, which is partially cut;
FIG. 3 is a plan view showing the actual picture of a TCP;
FIG. 4 is a sectional view of the TCP;
FIG. 5 is a lateral sectional view of a heat sink assembly apparatus for a TCP, which is used in a conventional plasma display apparatus;
FIG. 6 is a lateral sectional view of a driver IC package for a plasma display apparatus according to an embodiment of the present invention;
FIG. 7 is a lateral sectional view of a heat sink assembly apparatus for a plasma display apparatus according to an embodiment of the present invention;
FIG. 8 is a front view of a heat sink having a fixing hole according to an embodiment of the present invention; and
FIG. 9 is a plan view of a support frame according to an embodiment of the present invention.

Embodiments of the present invention will now be described in detail with reference to the accompanying drawings.

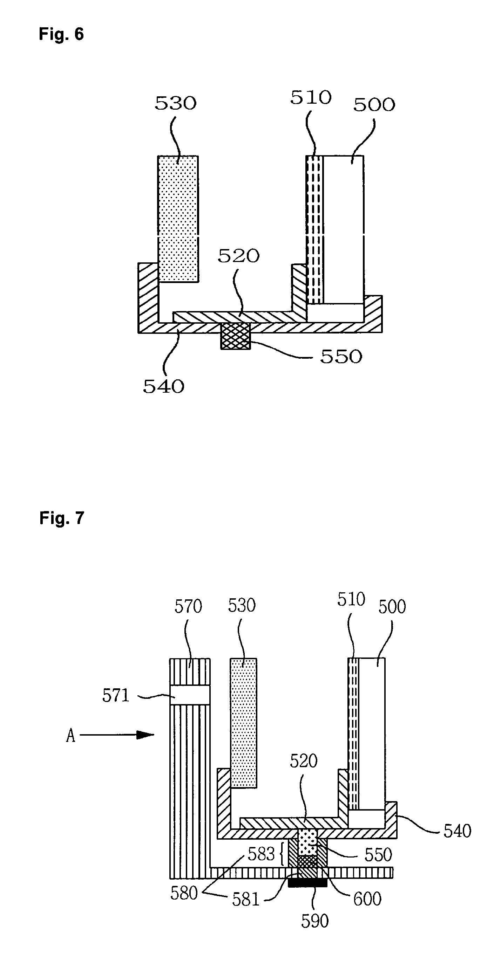

FIG. 6 is a lateral sectional view of a driver IC package for a plasma display apparatus according to an embodiment of the present invention.

As shown in FIG. 6, the driver IC package for the plasma display apparatus according to an embodiment of the present invention includes a driver IC 550 and a signal transfer film 540.

The driver IC 550 generates a driving pulse for driving electrodes of a plasma display panel 500 according to a control signal of the driving board 530.

The signal transfer film 540 is electrically connected to a driving board 530 and the electrodes of the plasma display panel 50. The driver IC 550 is located under the lateral side of the plasma display panel 500. At this time, the signal transfer film 540 can be a TCP film.

The signal transfer film 540 is supported by a support frame 520. The support frame 520 is connected to a heat radiation plate 510 attached to a bottom surface of the plasma display panel 500 and is attached to the signal transfer film 540.

In the driver IC package for the plasma display apparatus according to embodiments of the present invention, the driver IC 550 is located under the lateral side of the plasma display panel 500 by the signal transfer film 540. Thus, the length of the signal transfer film 540 can be shortened compared to the conventional one.

FIG. 7 is a lateral sectional view of a heat sink assembly apparatus for a plasma display apparatus according to an embodiment of the present invention.

As shown in FIG. 7, the heat sink assembly apparatus for the plasma display apparatus according to an embodiment of the present invention includes a driver IC 550, a signal transfer film 540, a heat sink 570, a first fastening unit 580 and a second fastening unit 590.

The driver IC 550 generates a driving pulse for driving a plasma display panel 500 according to a control signal of a driving board 530.

The signal transfer film 540 is electrically connected to the driving board 530 and electrodes of the plasma display panel 500. The driver IC 550 is located under the lateral side of the plasma display panel 500. The signal transfer film 540 can be a TCP film.

The heat sink 570 is spaced apart from the signal transfer film 540 by a predetermined distance and externally radiates heat of the signal transfer film 540. One side of the heat sink 570 has an approximately L shape so that it extends toward the rear surface of the driving board 530.

The first fastening unit 580 is located between the signal transfer film 540 and the heat sink 570 and separates the signal transfer film 540 and the heat sink 570 by a predetermined distance. The first fastening unit 580 is a pemnut. The first fastening unit 580 includes a distance sustain unit 583 and a passing-through portion 581. The distance sustain unit 583 maintains a distance between the signal transfer film 540 and the heat sink 570. The passing-through portion 581 penetrates the heat sink 570 and has a diameter smaller than that of the distance sustain unit 583.

The second fastening unit 590 screws the first fastening unit 580 to fix the heat sink 570. At this time, the second fastening unit 590 can be a screw. That is, a groove (not shown) for screw engagement with the second fastening unit 590 is formed in the passing-through portion 581 of the first fastening unit 580. The signal transfer film 540 and the heat sink 570 are coupled by means of screw engagement of the first fastening unit 580 and the second fastening unit 590.

The support frame 520 supports the signal transfer film 540. The support frame 520 is connected to the heat radiation plate 510 attached to the rear surface of the plasma display panel 500 and is attached to the signal transfer film 540. As the first fastening unit 580 and the second fastening unit 590 are coupled, the support frame 520, the heat sink 570 and the signal transfer film 540 are combined. Accordingly, the support frame 520 supports the signal transfer film 540.

At this time, a thermal pad 600 is inserted between the driver IC 550 and the heat sink 570. Accordingly, heat generated from the driver IC 550 is transferred to the heat sink 570 through the thermal pad 600.

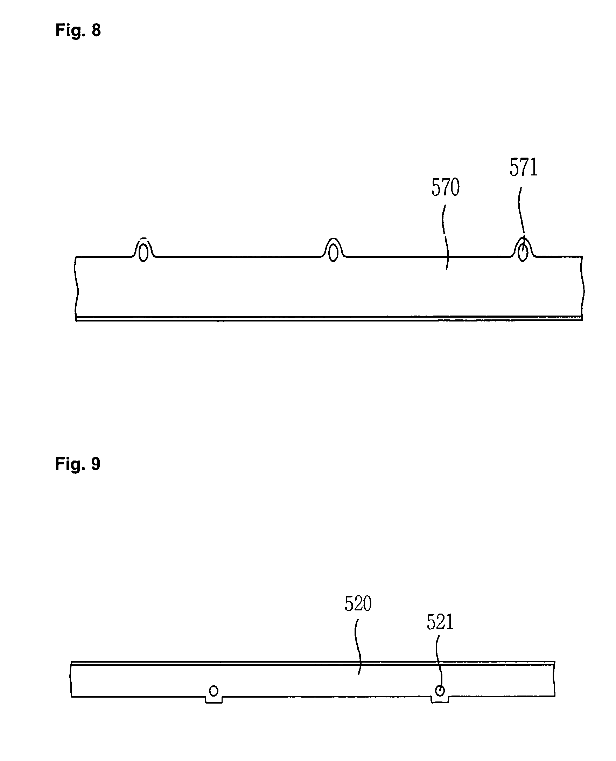

FIG. 8 is a front view of a heat sink having a fixing hole according to an embodiment of the present invention. The front view of FIG. 8 is one that is viewed in a direction "A" shown in FIG. 7.

As shown in FIG. 7, if the heat sink 570 and the signal transfer film 540 are combined by the first fastening unit 580 and the second fastening unit 590, the signal transfer film 540 or the support frame 520 may be deformed due to external strong shock or vibration. Accordingly, the heat sink 570 includes a fixing hole 571. As another fastening means such as the pemnut penetrates the fixing hole 571 of the heat sink 570 and is then coupled to predetermined support means, the heat sink 570 and the signal transfer film 540 can be protected from external strong shock or vibration.

At this time, the fixing hole 571 can be elliptical. If the signal transfer film 540 and the heat sink 570 are first coupled by the first fastening unit 580 and the second fastening unit 590 and the heat sink 570 is then fixed by further fastening means that penetrates the fixing hole 571 of the heat sink 570, machining error can be generated. Such machining error makes unstable the fastening state of the signal transfer film 540 and the heat sink 570. Accordingly, when the fixing hole 571 is elliptical, the effect on machining error can be reduced.

FIG. 9 is a plan view of a support frame according to an embodiment of the present invention.

As shown in FIG. 9, a fastening hole 521 is formed in the support frame 520. The fastening hole 521 is for the first fastening unit 580. The fastening hole 521 can be circular.

In embodiments of the present invention, in order to shorten the length of the signal transfer film 540, the driver IC 550 is located under the lateral side of the plasma display panel 500. In order for the driver IC 550 to be located under the lateral side of the plasma display panel 500, the support frame 520, the heat sink 570 and the signal transfer film 540 are coupled by the fastening of the first fastening unit 580 and the second fastening unit 590. Accordingly, the problem of mechanical interference occurring between elements having a predetermined height, which are mounted in the driving board 530, and the heat sink 570 can be solved. That is, in the conventional heat sink assembly apparatus, a distance between the driving board 530 and the heat sink 570 depends on a thickness of the driver IC 550. In the heat sink assembly apparatus according to embodiments of the present invention, however, a distance between the driving board 530 and the heat sink 570 can be increased as much as solving of mechanical interference because the support frame 520, the heat sink 570 and the signal transfer film 540 are coupled by the first fastening unit 580 and the second fastening unit 590.

Furthermore, if the support frame 520, the heat sink 570 and the signal transfer film 540 are coupled by the fastening of the first fastening unit 580 and the second fastening unit 590, an adhesive force between the support frame 520, the heat sink 570 and the signal transfer film 540 is improved. Therefore, a heat radiation characteristic can be improved. Furthermore, as heat radiation is performed by convection current with the driver IC 550 and the heat sink 570 being spaced apart from each other by a predetermined distance by the first fastening unit 580, a heat radiation characteristic can be improved. As described above, in the heat sink assembly apparatus according to an embodiment of the present invention, heat radiation is carried out by convection current and conduction. Accordingly, a heat radiation characteristic can be improved compared to conduction of heat through the conventional thermal tape.

As described above, according to a plasma display apparatus in accordance with an embodiment of the present invention, a driver IC is located under the lateral side of a plasma display panel, thus shortening the length of a signal transfer film. Accordingly, costs can be saved.

According to a plasma display apparatus in accordance with embodiments of the present invention, a driver IC is located under the lateral side of a plasma display panel through the fastening of a first fastening unit and a second fastening unit. Heat radiation efficiency can be maximized.

While the present invention has been described with reference to the particular illustrative embodiments, it is not to be restricted by the embodiments but only by the appended claims. It is to be appreciated that those skilled in the art can change or modify the embodiments without departing from the scope of the present invention.

## Claims

1. A plasma display apparatus comprising:
a plasma display panel including a plurality of electrodes;
a driver IC for generating a driving pulse to drive the plasma display panel; and
a signal transfer film electrically connected to the plurality of electrodes and the driver IC in such a fashion that the driver IC is located under a lateral side of the plasma display panel.

2. The plasma display apparatus of claim 1, further including:
a heat sink spaced apart from the signal transfer film by a predetermined distance for externally radiating heat of the signal transfer film;
a first fastening unit located between the signal transfer film and the heat sink for separating the signal transfer film and the heat sink by a predetermined distance; and
a second fastening unit coupled to the first fastening unit so as to fix the heat sink.

3. The plasma display apparatus of claim 2, further including a support frame for supporting the signal transfer film by way of the fastening of the first fastening unit and the second fastening unit.

4. The plasma display apparatus of claim 2 or claim 3, wherein the first fastening unit is a pemnut and the second fastening unit is a screw.

5. The plasma display apparatus of any preceding claim, wherein the signal transfer film is a TCP film.

6. The plasma display apparatus of any of claims 2 to 5, wherein the first fastening unit includes a distance sustain unit for sustaining a distance between the signal transfer film and the heat sink, and a passing-through portion that penetrates the heat sink and has a diameter smaller than that of the distance sustain unit.

7. The plasma display apparatus of any of claims 2 to 6, wherein a thermal pad is inserted between the driver IC and the heat sink.

8. The plasma display apparatus of any of claims 2 to 7, wherein the heat sink includes a fixing hole.

9. The plasma display apparatus of claim 8, wherein the fixing hole is elliptical.

10. The plasma display apparatus of any of claims 2 to 9, wherein the heat sink extends at one side toward a rear surface of the driving board.

11. A heat sink assembly apparatus for a plasma display panel comprising:
a driver IC for generating a driving pulse to drive the plasma display panel;
a signal transfer film electrically connected to the plasma display panel and the driver IC in such a fashion that the driver IC is located under a lateral side of the plasma display panel;
a heat sink spaced apart from the signal transfer film by a predetermined distance, for externally radiating heat of the signal transfer film;
a first fastening unit located between the signal transfer film and the heat sink, for separating the signal transfer film and the heat sink by a predetermined distance; and
a second fastening unit coupled with the first fastening unit so as to fix the heat sink.

12. The heat sink assembly apparatus of claim 11, further including a support frame for supporting the signal transfer film by way of the fastening of the first fastening unit and the second fastening unit; and/or
wherein the first fastening unit is a pemnut and the second fastening unit is a screw; and/or
wherein the signal transfer film is a TCP film; and/or
wherein the first fastening unit includes a distance sustain unit for sustaining a distance between the signal transfer film and the heat sink, and a passing-through portion that penetrates the heat sink and has a diameter smaller than that of the distance sustain unit; and/or
wherein a thermal pad is inserted between the driver IC and the heat sink; and/or
wherein the heat sink includes a fixing hole, said fixing hole being, optionally, elliptical; and/or
wherein the heat sink extends at one side toward a rear surface of the driving board.
